# EUROPEAN PATENT APPLICATION

(11) **EP 1 139 399 A2**
(43) Date of publication of application: **04.10.2001**
(21) Application number: 01106454.0
(22) Date of filing: 23.03.2001
(51) Int. Cl.: H01L 21/306, H01L 21/316

(54) **Film-forming surface reforming method and semiconductor device manufacturing method**

(30) Priority: 31.03.2000 JP 2000098262; 09.01.2001 JP 2001001759
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Maeda, Kazuo, Semiconductor Process Lab. Co. Ltd., Tokyo 108-0075 (JP); Suzuki, Setsu, Semiconductor Process Lab. Co. Ltd., Tokyo 108-0075 (JP); Azumi, Takayoshi, Semicond. Process Lab. Co. Ltd., Tokyo 108-0075 (JP); Sasaki, Kiyotaka, Canon Sales Co., Inc., Tokyo 108-0073 (JP)
(74) Representative: Schwabe - Sandmair - Marx

(57) **Abstract**

There is provided a film-forming surface reforming method that comprises the steps of bringing a gas or an aqueous solution containing ammonia, hydrazine, amine, amino compound or their derivative into contact with a film-forming surface (12a) before an insulating film (15) is formed on the film-forming surface (12a) of a substrate (102), and
bringing a gas or an aqueous solution containing hydrogen peroxide, ozone, oxygen, nitric acid, sulfuric acid or their derivative into contact with the film-forming surface (12a).

## Description

### BACKGROUND OF THE INVENTION

### 1. Field of the Invention

The present invention relates to a film-forming surface reforming method and a semiconductor device manufacturing method and, more particularly, to a film-forming surface reforming method for improving a surface dependency of the film-forming surface (sometimes referred to simply as a "surface dependency" hereinafter) in film formation before a film is formed by a thermal chemical vapor deposition method (thermal CVD method) using a reaction gas (referred to as an "O₃/TEOS reaction gas" hereinafter) containing a TEOS (TetraEthylOrthoSilicate) and an ozone-containing gas including ozone (O₃) in the oxygen (O₂) and, and to a semiconductor device manufacturing method employing this reforming method. The surface dependency means that film formation of the CVD film grown on the film-forming surface is affected in the growth rate, etc. by chemical properties of the film-forming surface.

### 2. Description of the Prior Art

In recent years, with the progress of the super high density and the multi-layered wiring of the semiconductor device, the development of technology for forming such an insulating film is demanded that is superior in surface planarity, recess filling property, and in step coverage, and that suppresses the permeation of the moisture and the impurity. As the film forming technology of the insulating film to satisfy these demands, there is the method of forming the film by the CVD method using the O₃/TEOS reaction gas. In this case, the excellent film property can be obtained if the O₃ concentration is set higher.

In contrast, the film formation depends strongly upon the state of the film-forming surface. The influence of such surface dependency does not appear under the condition (low O₃ condition) of low O₃ concentration, but appears remarkably under the condition (high O₃ condition) of high O₃ concentration.

In the following description, the O₃/TEOS reaction gas having the high O₃ concentration is called a "high O₃/TEOS reaction gas", and a silicon dioxide film formed by the CVD method using this reaction gas is called the "high O₃/TEOS SiO₂ film". Also, the O₃/TEOS reaction gas having the low O₃ concentration is called a "low O₃/TEOS reaction gas", and a silicon dioxide film formed by the CVD method using this reaction gas is called a "low O₃/TEOS SiO₂ film". In addition, the silicon dioxide film formed by the CVD method using the O₃/TEOS reaction gas containing all O₃ concentrations is simply called an "O₃/TEOS SiO₂ film".

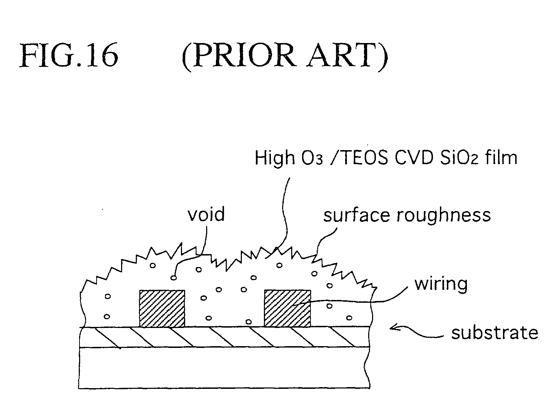

FIG.16 is a sectional view showing the state in which the film is abnormally grown by the influence of the surface dependency.

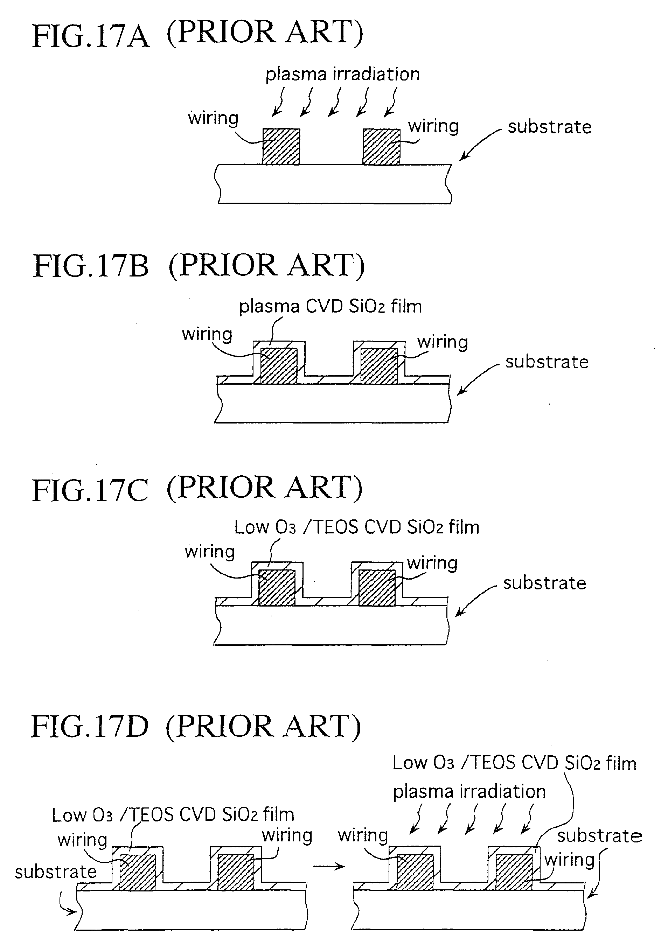

In the prior art, in order to eliminate such surface dependency, the methods shown in FIGS.17A to 17D are employed. These methods are
(i) a method of irradiating the plasma onto the film-forming surface (FIG.17A),
(ii) a method of covering the film-forming surface by the plasma CVD SiO₂ film (FIG.17B),
(iii) a method of forming the low O₃/TEOS CVD SiO₂ film as the underlying layer prior to film formation of the high O₃/TEOS CVD SiO₂ film (FIG.17C), and
(iv) a method of forming the thin low O₃/TEOS CVD SiO₂ film, irradiating the surface of the film with the plasma, and forming the high O₃/TEOS CVD SiO₂ film on the low O₃/TEOS CVD SiO₂ film(FIG.17D). In the above (iii) and (iv), the double layer consisting of the low O₃/TEOS CVD SiO₂ film and the high O₃/TEOS CVD SiO₂ film is employed.

However, the conventional methods have following problems respectively.
(i) According to the method of irradiating the plasma onto the film-forming surface, conditions exhibiting the surface dependency suppressing effect are varied. Therefore, since the condition can neither be standardized nor shared for all film-forming surface, the condition must be optimized for each film-forming surfaces.
   In addition, the plasma CVD equipment must be separately prepared to irradiate the plasma.
(ii) According to the method of covering the film-forming surface with the plasma CVD SiO₂ film, for some process condition of the plasma CVD SiO₂ film, a film that is compatible to the high O₃/TEOS CVD SiO₂ film can be obtained, which in turn forms the high O₃/TEOS CVD SiO₂ film that exhibits good film property. However, since the plasma CVD SiO₂ film has bad step coverage, the plasma CVD SiO₂ film is not suitable for the fine patterning. Also, the plasma CVD equipment must be separately prepared.
(iii) According to the method of covering the film-forming surface with the low O₃/TEOS CVD SiO₂ film, since the low O₃/TEOS CVD SiO₂ film has the very good affinity to the high O₃/TEOS CVD SiO₂ film, the surface dependency can be eliminated. However, the low O₃/TEOS CVD SiO₂ film shows isotropic growing characteristics, and the film thickness of at least 100 nm is needed to use the film as the underlying film that eliminate the surface dependency.
   Therefore, such low O₃/TEOS CVD SiO₂ film is unsuitable for the fine patterning.
   Though the method of eliminating the surface dependency by using the low O₃/TEOS CVD SiO₂ film that was formed under low pressure was examined, this film was essentially the same as the low O₃/TEOS CVD SiO₂ film, and therefore was unsuitable for the fine patterning for the same reason.
(iv) According to the method of covering the film-forming surface by the low O₃/TEOS CVD SiO₂ film and then irradiating the plasma onto the film, steps of the method become complicated.

In this manner, the conventional methods are generally not suitable for filling a narrow and deep recess. On the centrally to this, recent demand on high density of semiconductor device requires a method for forming interlayer or cover insulating film that have superior film property, and that especially can fill the narrow and deep recess.

### SUMMARY OF THE INVENTION

It is an object of the present invention to provide a film-forming surface reforming method capable of almost completely eliminating the surface dependency of the film-forming surface by an extremely simple approach without using additional energy such as plasma irradiation or high temperature heating, and process in the vacuum, etc..

Another object of the present invention is to provide a semiconductor device manufacturing method employing this reforming method.

In a film-forming surface reforming method of the present invention, a gas or an aqueous solution containing any one selected from the group consisting of ammonia, hydrazine, amine, amino compound, and their derivative is brought into contact with a film-forming surface, and then a gas or an aqueous solution containing any one selected from the group consisting of hydrogen peroxide, ozone, oxygen, nitric acid, sulfuric acid, and their derivative is brought into contact with the film-forming surface.

The gas or the aqueous solution containing any one selected from the group consisting ammonia, hydrazine, amine, amino compound, and their derivative can etch the silicon oxide film and the silicon nitride film exposed on the film-forming surface. The surface of the silicon oxide film or the silicon nitride film that is etched in this manner is brought into the chemically active state, and hence the film-forming surface is easily oxidized by bringing the gas or the aqueous solution containing hydrogen peroxide, ozone, oxygen, nitric acid, sulfuric acid or their derivative into contact with the active film-forming surface, whereby a thin oxide film can be formed on the film-forming surface.

According to the experiment, it has been confirmed that if the very thin oxide film is newly formed by the oxidizing process after the surface of the film-forming surface (surface of silicon nitride film etc.) is etched as described above, a high O₃/TEOS CVD SiO₂ film can be formed on the film-forming surface to have good compatibility to the oxide film and to show no surface dependency.

Since the silicon nitride film is a very stable compound, it cannot, in general, be oxidized at the room temperature. When a thermal oxidizing method using oxygen is employed for oxidizing the silicon nitride film, it requires a heat treatment at the high temperature near 1000 °C. Since the high temperature treatment destroys the structure of the semiconductor device constituting the substrate, such high temperature treatment cannot be employed.

On the centrally to this, according to the present invention, after the film-forming surface is chemically activated by the etching, the film-forming surface is oxidized. Therefore, the film-forming surface can be oxidized at the low temperature close to the room temperature, and thus the surface dependency can be easily eliminated.

Particularly, since the aqueous solution containing the ammonia or the hydrazine compound has a small surface tension, and the gas of the reforming agent can be diffused into the narrow and deep recess portion, both the solution and the gas can eliminate the surface dependency in such minute recess portion.

Accordingly, the interlayer or cover insulating film, which is formed using the thermal CVD method and is formed on the film-forming surface whose surface dependency is eliminated, exhibits no surface roughness and voids, together with exhibiting no reduction in the film forming rate, and can fill the narrow and deep recess portion completely.

Further, as the result of experiments, followings become apparent.

① If the film-forming surface is the surface of the silicon nitride film, the surface dependency can be eliminated merely by exposing the surface to the hydrogen peroxide water.

② If the film-forming surface is the surface of the silicon oxide film, the surface dependency can be eliminated merely by exposing the surface to the aqueous solution containing any one of NO₂⁻ and NO₃⁻.

In particular, in the case of ② , above NO₂⁻ and NO₃⁻ can be naturally produced in the mixed solution containing the ammonia (NH₃), the hydrogen peroxide (H₂O₂), and the pure water (H₂O). In this case, the NO₂⁻ and NO₃⁻ concentration that is effective in eliminating the surface dependency can be adjusted by mixing the ammonia (NH₃), the hydrogen peroxide (H₂O₂), and the pure water (H₂O) to prepare the mixed solution, and then keeping the mixed solution at a predetermined temperature for a predetermined time.

Alternatively, the above NO₂⁻ and NO₃⁻ can be produced by employing the aqueous solution into which the nitric acid (HNO₃) is further added. In this case, the NO₂⁻ and NO₃⁻ concentration that is effective in eliminating the surface dependency can be adjusted to a desired value by adjusting the concentration of the added nitric acid (HNO₃).

### BRIEF DESCRIPTION OF THE DRAWINGS

FIG.1 is a flowchart showing a surface reforming method according to a first embodiment of the present invention;
FIGS.2A to 2D are sectional views showing the surface reforming method according to the first embodiment of the present invention;
FIGS.3A to 3C are views showing states of the surface of the underlying layer formed of the SiO₂ film in a series of steps in reforming process according to the first embodiment of the present invention;
FIGS.4A to 4C are views showing states of the surface of the underlying layer formed of the SiN film in a series of steps in the reforming process according to the first embodiment of the present invention;
FIG.5 is a graph showing the growth rate of the high O₃/TEOS CVD SiO₂ film versus the concentration of the ammonia aqueous solution of the etching agent according to the first embodiment of the present invention;
FIG.6 is a graph showing the growth rate of the high O₃/TEOS CVD SiO₂ film versus the NH₃ concentration of the etching agent, when mixed liquid of the aqueous ammonia and the hydrogen peroxide water was employed as the etching agent in the first embodiment of the present invention;
FIGS.7A to 7C are sectional views showing a substrate surface reforming method according to a second embodiment of the present invention when an underlying surface is formed of a silicon nitride film;
FIG.8 is a graph showing a relationship between a H₂O₂ concentration and a growth rate ratio when the underlying surface is formed of the silicon nitride film, in the second embodiment of the present invention;
FIGS.9A to 9C are sectional views showing a surface reforming method according to the second embodiment of the present invention when the underlying surface is formed of a silicon oxide film;
FIG.10 is a graph showing a relationship between a heat-insulating time and the growth rate ratio when liquids having a volume ratio 1:1:5 and 1:10:50 for an aqueous ammonia (30 wt%), a hydrogen peroxide water (30 wt%), and a pure water are used as the surface reforming liquids when the underlying surface is formed of the silicon oxide film, in the second embodiment of the present invention;
FIG.11 is a graph showing a relationship between the heat-insulating time and a concentration of nitric acid based ions in the surface reforming liquid at a temperature of 80 °C, in the second embodiment of the present invention;
FIG.12 is a graph showing a relationship between a concentration of the nitric acid and the growth rate ratio when the nitric acid is intended to be added into the surface reforming liquid when the underlying surface is the silicon oxide film, in the second embodiment of the present invention;
FIG.13A is a flowchart showing the surface reforming process when the underlying layer is the silicon nitride film, and FIG.13B is a flowchart showing the surface reforming process when the underlying layer is the silicon oxide film, in the second embodiment of the present invention;
FIG.14 is a sectional view showing the surface reforming method according to First Example of the present invention;
FIG.15A is a sectional view showing the surface reforming method according to Second Example of the present invention, and FIG.15B is a sectional view showing Comparative Example when the film is formed without the reforming process;
FIG.16 is a sectional view showing the state after the CVD film is formed on the film-forming surface in the prior art; and
FIGS.17A to 17D are sectional views showing the reforming processes of the film-forming surface in the prior art.

### DESCRIPTION OF THE PREFERRED EMBODIMENTS

Embodiments of the present invention will be explained with reference to the accompanying drawings hereinafter.

### (Approach to the present invention and the principle of the present invention)

The approach to the present invention and the principle of the present invention will be explained hereunder.

If the film is formed on the film-forming surface of the silicon oxide film (the SiO₂ film, etc.), the silicon nitride film (whose chemical formula is expressed as Si₃N₄ etc., but sometimes abbreviated as the "SiN film" hereinafter), or the like, film formation depends strongly upon the state of the film-forming surface and hence the film formation exhibits the abnormal growth. For example, if the film is formed on the surface of the thermal oxide film, or of the plasma CVD film that is not compatible to the O₃/TEOS reaction gas, or of the underlying insulating film formed by the low pressure thermal CVD method, the formed film shows porosity, surface roughness, or reduction in the film forming rate. These disadvantages are caused since the formed film is strongly influenced by chemical properties of the film-forming surface.

When being left in clean room in which moisture is present, the surfaces of the silicon oxide film and the silicon nitride film adsorbs H₂O or hydrates by OH group, which in turn makes the surfaces chemically inactive and hydrophilic. These act as primary factors to disturb the smooth and uniform adsorption of the intermediate reaction product of the O₃/TEOS reaction gas, which exhibits the oiliness, onto the film-forming surface. This disturbs uniform film formation, the recess filling property, and the uniform flowability during the formation of the high O₃/TEOS NSG film (the NSG film means the silicon oxide film that does not contain the impurity such as phosphorus, boron, or the like).

Accordingly, it is supposed that the abnormal film formation can be suppressed if the adsorption sites for the intermediate product are increased in the film-forming surface to promote uniform adsorption.

According to the plasma irradiation of the conventional method, the moisture on the surface, etc. can be removed by the plasma irradiation and the heat, and hence the defects are introduced into the insulating film and also the minute surface unevennesses are formed on the film-forming surface. It may be supposed that the defects in the insulating film and the minute surface unevennesses act as the surface adsorption sites for the intermediate product of the O₃/TEOS reaction gas.

In the case of the conventional method that employs the low O₃/TEOS CVD SiO₂ film as the underlying layer, it is supposed that since the low O₃/TEOS CVD SiO₂ film is inferior in film property compared to the high O₃/TEOS CVD SiO₂ film and thus many defects are contained in the film, these defects act as the adsorption sites for the intermediate product to promote the uniform adsorption of the intermediate product.

The thermal oxide film, and the silicon oxide film and the silicon nitride film formed by the thermal CVD method is very superior in film property and thermally stable and does not contain many defects in the film. If it is tried to chemically form the silicon oxide film on these surfaces, the high temperature such as about 1000 °C is required to directly oxidize the films because the silicon oxide film and the silicon nitride film are chemically stable.

It is well known that the inorganic or organic alkaline aqueous solution can dissolve the surfaces of the silicon oxide film and the silicon nitride film and thus exhibit etching property against these films. The film-forming surface that is etched by these etching agents is chemically active and has minute unevenness or etching pores. The state in which a large number of pores are formed is called the porous state. It is considered that since the surface area of such surface is increased by the etching pores and such surface is chemically active, the surface can easily be oxidized by the oxidizing agent and thus the extremely thin oxide layer can be formed on the surface.

It is considered that the silicon oxide film formed chemically in this manner contains a large number of defects in the film and thus the surface becomes the porous state. The defects in the film and the minute surface unevenness can act as the surface adsorption sites for the intermediate product of the O₃/TEOS reaction gas, which in turn promotes the uniform adsorption of the intermediate product to the surface, and thus promotes the film formation of the high O₃/TEOS CVD SiO₂ film, and thereby eliminates the surface dependency completely. Thus, the film formation can be performed with maintaining the totally same growth rate and film property as those obtained when the film is formed on the silicon substrate surface.

The etching agent and the oxidizing agent employed in the present invention will be listed in the following and explained simply hereunder.

### (Etching agent)

In the present invention, inorganic or organic alkali is employed as the etching agent. More specifically, ammonia (NH₃), hydrazine ((NH₂)₂), or an amino group (-NH₂) based compound are employed. The reasons for employing the inorganic or organic alkali as the etching agent are that the substantially equal etching rate can be obtained irrespective of the type of the silicon oxide film and the silicon nitride film and that the surface dependency can be completely eliminated. In contrast, a fluorine-based etching agent is not suitable for the etching agent of the present invention since firstly the etching rate of the silicon oxide film becomes extremely quicker than that of the silicon nitride film, and secondly it is difficult to eliminate the surface dependency of the film-forming surface made of the silicon oxide film.

### (a) Ammonia (NH₃)

The ammonia is a gas at the normal temperature. The aqueous solution is the aqueous ammonia NH₃ H₂O. In the following, for convenience of explanation, in some cases the aqueous ammonia is called the ammonium hydroxide NH₄OH. Also, the compound expressed by the chemical formula NHₙR₄₋ₙOH (n=1 to 4, R: alkyl group) may be employed as the derivative of the ammonium hydroxide. For example, if n=2 and CH₃ is employed as R in the above chemical formula, the dimethylammonium hydroxide (N(CH₃)₂H₂OH) is obtained.

### (b) Hydrazine ((NH₂)₂)

The hydrazine is a liquid at the normal temperature. The aqueous solution is the hydrazine-hydrate (N₂H₄H₂O, N₂H₅OH), and becomes the alkali. Also, (NR₂)₂ (R is the alkyl group such as CH₃, C₂H₅, C₃H₇, etc., or the aryl group (including the benzene nucleus), or the like) may be employed as the derivative of the hydrazine. If R is CH₃, the dimethylhydrazine N₂(CH₃) is obtained.

### (c) Amine

The amine is the compound in which the hydrogen atom of the ammonia is replaced with the organic group (R) such as the alkyl group, the aryl group (including the benzene nucleus), etc., and belongs to the organic alkali.

NRₙH₃₋ₙ (n=1,2,3), etc. may be used as the amine.

### (d) Amino compound

The amino compound is the organic compound having the amino group (-NH₂).

The aminobenzene (aniline) (C₆H₅NH₂), the aminophenol (C₆H₄NH₂OH), etc. may be used as the amino compound.

Common features of these etching agents of (a) to (d) are that (i) they have properties as the alkali, (ii) they can be used as the aqueous solution or the solution, and (iii) they are adsorbed onto the film-forming surface of the silicon oxide and the silicon nitride to show the excellent wettability. Accordingly, the etching agent of the present invention is not limited to the particular examples given in above (a) to (d), but any agent may be used as the etching agent of the present invention if it has above properties.

### (Oxidizing agent)

In the present invention, the gas or the aqueous solution containing any one selected from the group consisting of hydro peroxide, ozone, oxygen, nitric acid, sulfuric acid, and their derivative is used as the oxidizing agent.

### (a)Hydrogen peroxide

The hydro peroxide is a liquid at the normal temperature. The hydro peroxide is dissociated to produce the water (H₂O) and the oxygen atom (O) in the nascent state. The hydro peroxide is known as the strong oxidizing agent.

### (b) Ozone

The ozone is a gas at the normal temperature. The ozone is dissociated to produce the oxygen molecule (O₂) and the oxygen atom (O) in the nascent state. Also, the ozone is dissolved into the water to form the ozone water which can be used as the oxidizing agent.

### (c) Nitric acid (HNO₃) and Sulfuric acid (H₂SO₄)

Both the nitric acid and the sulfuric acid are a liquid at the normal temperature. Aqueous solution of these acids with high concentration exhibits the oxidizing property. Also, the nitrous acid (HNO₂) and the sulfurous acid (H₂SO₃) can be used as the oxidizing agent.

Common features of these oxidizing agents of (a) to (c) are that (i) they have features as the oxidizing agent in a vapor phase or in a solution, (ii) they can be used as the gas, the aqueous solution, and the solution, (iii) they are adsorbed onto the film-forming surface of the silicon oxide and the silicon nitride to show the excellent wettability, and (iv) they do not dissolve the generated silicon oxide. Accordingly, the oxidizing agent of the present invention is not limited to the particular examples given in above (a) to (c), but any agent may be used as the oxidizing agent of the present invention if it has above properties.

In the following explanation, in some cases the above etching agent and the above oxidizing agent are called as a "surface reforming liquid".

### (First Embodiment)

Next, a film-forming surface reforming method according to a first embodiment of the present invention and a semiconductor device manufacturing method employing this reforming method will be explained hereunder.

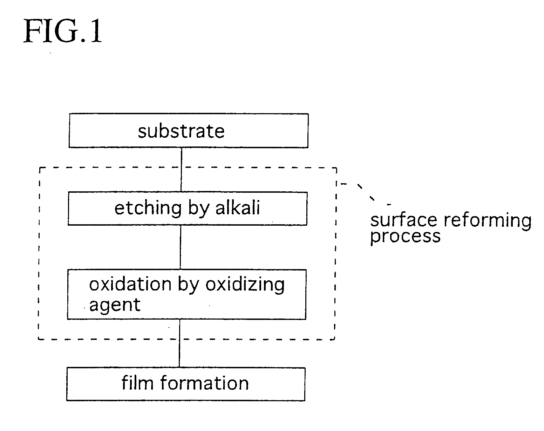

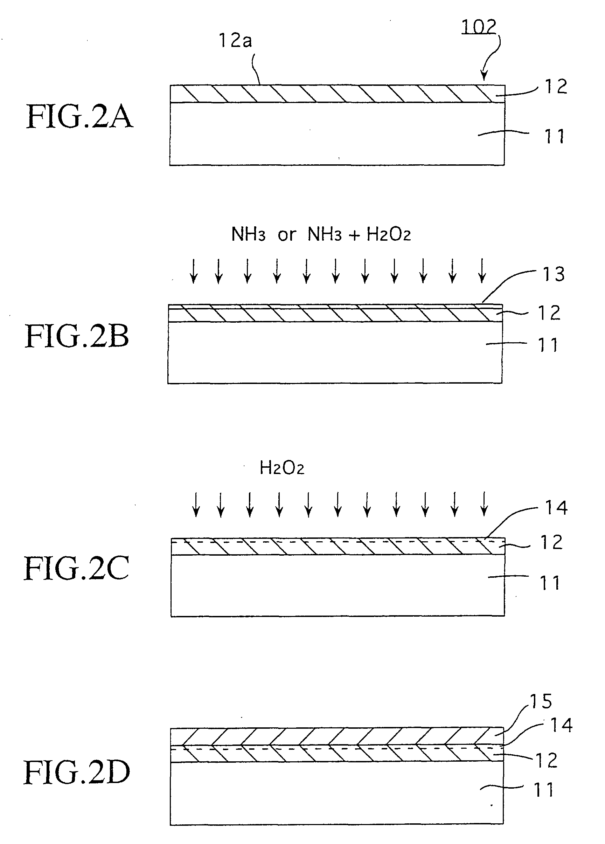

FIG.1 is a flowchart showing the film-forming surface reforming method according to the first embodiment of the present invention and a semiconductor device manufacturing method employing this reforming method. FIGS.2A to 2D are sectional views showing the film-forming surface reforming method and the semiconductor device manufacturing method according to the first embodiment of the present invention.

First, an underlying layer 12 is formed on a semiconductor substrate 11 made of silicon. If the silicon oxide film is formed as the underlying layer 12, the semiconductor substrate 11 is put into the oxidizing furnace and then heated up to about 1100 °C in the oxygen atmosphere. Accordingly, as shown in FIG.2A, a surface of the semiconductor substrate 11 is oxidized and thus the thermal oxide film (underlying layer) 12 made of SiO₂ is formed.

Also, if the silicon nitride film is formed as the underlying layer 12, the semiconductor substrate 11 made of silicon is put into the low pressure CVD equipment, and then the silicon nitride film (underlying layer) 12 is formed at about 750 °C by the low pressure CVD method using the reaction gas consisting of the dichlorsilane (SiH₂Cl₂) and the ammonia (NH₃).

The silicon oxide film and the silicon nitride film serve as the underlying layer 12 in the film formation, and a surface of the underlying layer 12 serves as a film-forming surface 12a. These constitute a substrate 102. In some cases, wirings are formed on the thermal oxide film or of the silicon nitride film 12. In this case, the overall structure including the wirings constitute the substrate 102.

In the step of forming this underlying layer 12, the plasma CVD method, the low pressure CVD method, etc. may be employed in the alternative.

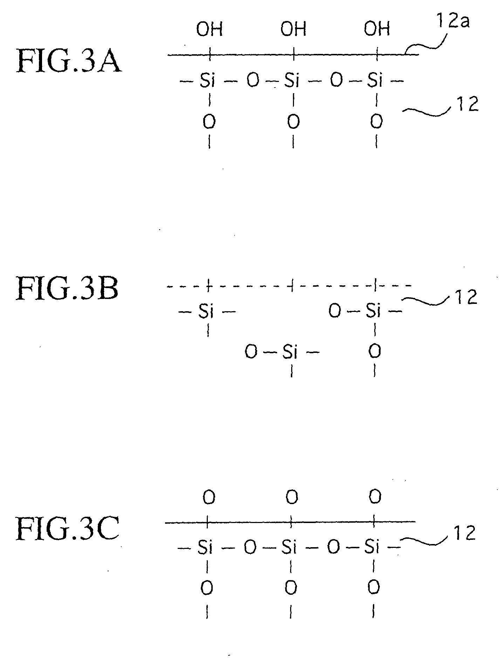

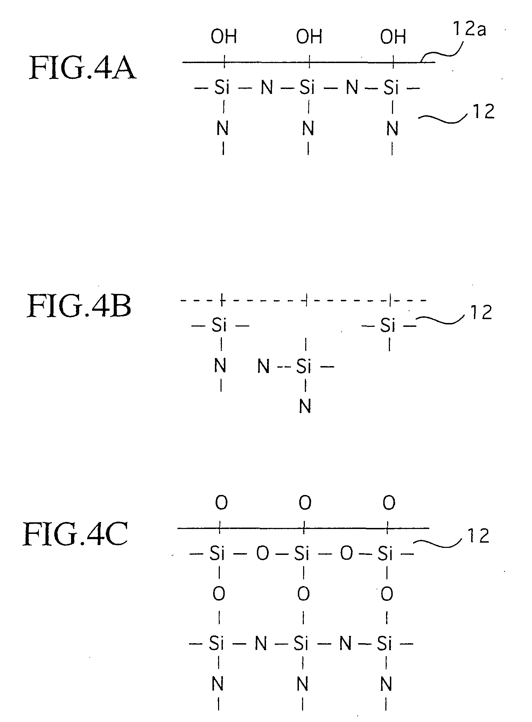

As shown in FIG.3A or FIG.4A, on the surface of the underlying layer 12 immediately after it is formed, both the silicon oxide film and the silicon nitride film come into contact with the air (containing the moisture) to be hydrated, and thus they are brought into the chemically inactive state.

Then, as shown in FIG.2B, the substrate 102 is dipped into an etching agent made of the aqueous ammonia or of the mixed solution of NH₃+H₂O₂. At this time, the surface of the underlying layer 12 is etched by the ammonia and thus a porous layer 13 is formed on a surface layer. A number of dangling bonds of silicon are formed in the porous layer 13. The surface state of the underlying layer 12 is shown in FIG.3B or FIG.4B.

Then, as shown in FIG.2C, the substrate 102 is dipped into the hydrogen peroxide water (oxidizing agent) after the substrate 102 is rinsed. This permits the dangling bonds of silicon atom contained in the porous layer 13 to bond to oxygen atom, thereby the porous layer 13 is oxidized. By this oxidization, the surface of the underlying layer 12 is covered with very thin layer 14 which is made up of silicon oxide. The surface state of the underlying layer 12 at this time is shown in FIG.3C or FIG.4C.

Then, after the substrate 102 is rinsed, the film-forming surface 12a is dried by the heating, the spin drying, etc.. Alternatively, the residual water on the surface may be removed in the isopropyl alcohol steam. When completing this step, the surface reforming process is completed.

Subsequent to the above reforming process, the substrate 102 is put into a reaction chamber of the film forming equipment, and then the high O₃/TEOS film forming gas is supplied into the reaction chamber.

Then, the substrate 102 is heated in the temperature range of 400 to 500 °C to make O₃ and TEOS to thermally react with each other. Then, as shown in FIG.2D, a high O₃/TEOS CVD SiO₂ film 15 is formed on the underlying layer 12 after such state is held for a predetermined time.

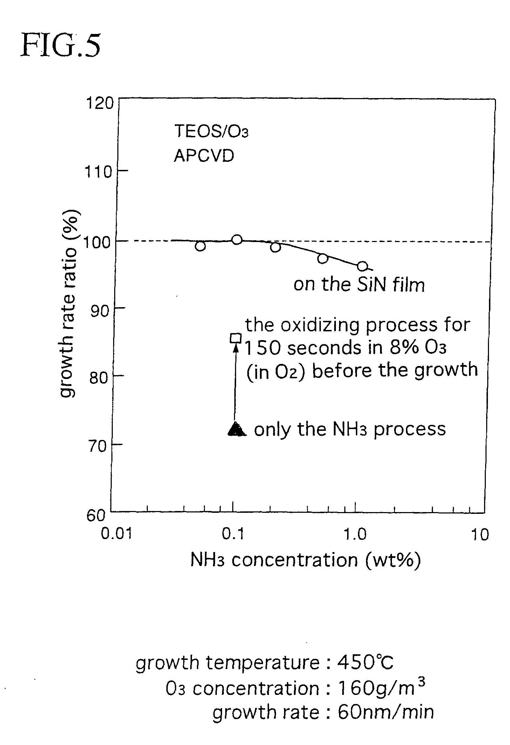

FIG.5 is a graph showing the growth rate of the high O₃/TEOS CVD SiO₂ film versus the concentration of the ammonia aqueous solution of the etching agent. In this experiments, sample was subjected to two-step process, in which the surface treatment using ammonia aqueous solution and oxidizing agent ware separately carried out as described above. Exposed on the surface of the sample was silicon nitride film, which serve as the underlying layer and whose surface serves as the film-forming surface.

An ordinate denotes the growth rate ratio (%) represented in a linear scale, and an abscissa denotes the NH₃ concentration (wt %) represented in a logarithmic scale. The growth rate ratio is defined as a ratio of the growth rate on the surface under consideration to that on the surface of a silicon single crystal substrate that exhibits no surface dependency. In this experiment, the growth rate on the silicon single crystal substrate was 60 nm/min, and the growth rate ratio was calculated based on this value. For the sake of comparison, other growth rates ratio is measured when the high O₃/TEOS CVD SiO₂ film is formed on the surface that was subjected only to the treatment using the NH₃ but not to the treatment using the oxidizing agent. A ▲ mark indicates the growth rate ratio of the sample which was subjected to such surface treatment. A □ mark indicates the growth rate ratio on the sample that was subjected to the surface treatment using the NH₃, followed by a surface oxidation for 150 seconds by heating at the temperature of about 450 °C in the atmosphere containing O₃ by 8 mol% in O₂ before the film formation.

As shown in FIG.5, the growth rate ratio of the high O₃/TEOS CVD SiO₂ film shows a value close to 100 % in the wide range of the ammonia concentration of 0.05 wt% to 1.0 wt%. In contrast, the growth rate ratio is only about 60 % in the sample indicated by the ▲ mark, whereas the growth rate ratio is considerably improved to about 87 % in the sample indicated by the □ mark.

It can be understood based on this that not only the etching process by the aqueous ammonia but also the subsequent oxidizing process in the hydrogen peroxide water or the ozone atmosphere is effective to eliminate the surface dependency of the film formation of the high O₃/TEOS CVD SiO₂ film. As shown in FIG.5, among various samples, the sample that is subjected to the surface treatment using ammonia aqueous solution having the ammonia concentration of less than 0.1 wt% is particularly preferable. Accordingly, the high O₃/TEOS CVD SiO₂ film having no void and the smooth surface can be formed.

Other case was also examined, in which a mixed liquid of the aqueous ammonia and the hydrogen peroxide water was employed instead of the above aqueous ammonia as the etching agent. In this experiment, the ammonia concentration in the aqueous ammonia is changed between 0.1 to 1.6 wt% while keeping the concentration of the hydrogen peroxide water constant at 4 wt% was employed.

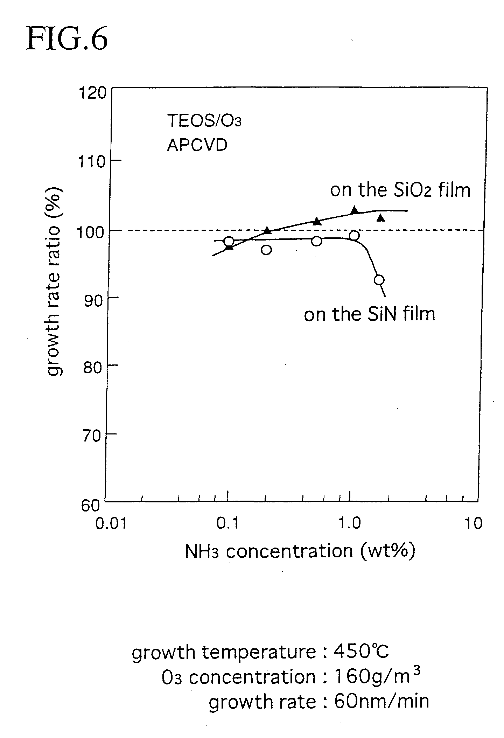

FIG.6 is a graph showing the results. An ordinate denotes the growth rate ratio (%) represented in a linear scale, and an abscissa denotes the NH₃ concentration (wt %) represented in a logarithmic scale. The growth rate ratio is calculated based on the growth rate 60 nm/min on the silicon single crystal substrate that has no surface dependency.

For the sake of comparison, the growth rate ratio (○ mark) obtained when the high O₃/TEOS CVD SiO₂ film is formed on the silicon oxide film (SiO₂ film) and the growth rate ratio (▲ mark) obtained when the high O₃/TEOS CVD SiO₂ film is formed on the silicon nitride film (SiN film) were examined.

As shown in FIG.6, in both the ○ mark and ▲ mark samples, the growth rate ratio of the high O₃/TEOS CVD SiO₂ film shows a value close to 100 % in the wide range of the ammonia concentration from 0.05 wt% to 1.0 wt%. Accordingly, the high O₃/TEOS CVD SiO₂ film having no void and the smooth surface can be formed.

In other experiment, the growth rate was measured when executing neither the etching treatment using the NH₃ nor the oxidizing treatment. Obtained growth rate ratio was only of about 40 % on the thermal oxide film and of about 60 % on the silicon nitride film, which is apparently inferior compared to the present invention.

As described above, according to the first embodiment of the present invention, since the film formation using the O₃/TEOS reaction gas is carried out after reforming the film-forming surface, especially the surfaces of the silicon oxide film or the silicon nitride film, the flowability, the planarity, the recess filling property, and the step coverage of the formed high O₃/TEOS CVD SiO₂ film 13 can be improved.

In particular, since the film-forming surface is covered with the chemically stable layer 14 made of the silicon oxide, the reforming effect can be maintained. That is, even if the substrate 102 was left in the air for 10 days or more after its film-forming surface 12a was reformed, the high O₃/TEOS CVD SiO₂ film 13 could be formed on the surface 12a with good flowability, the planarity, the recess filling property, and the step coverage.

### (Second Embodiment)

Next, a film-forming surface reforming method and a semiconductor device manufacturing method employing this reforming method according to a second embodiment of the present invention will be explained hereunder.

In the first embodiment of the present invention, two-step surface reforming process such as (the etching by the alkali)+(the oxidation by the oxidizing agent) is performed (see FIG.1). This two-step surface reforming process is effective in both cases, i.e., the case where the underlying layer is the silicon oxide film and the case where the underlying layer is the silicon nitride film.

However, if the underlying layer is of either the silicon oxide film or the silicon nitride film, one-step process described hereunder is also effective. This one-step process will be explained hereunder. In the following, the wordings defined in the first embodiment are not defined once again.

### (The case where the underlying layer is the silicon nitride film)

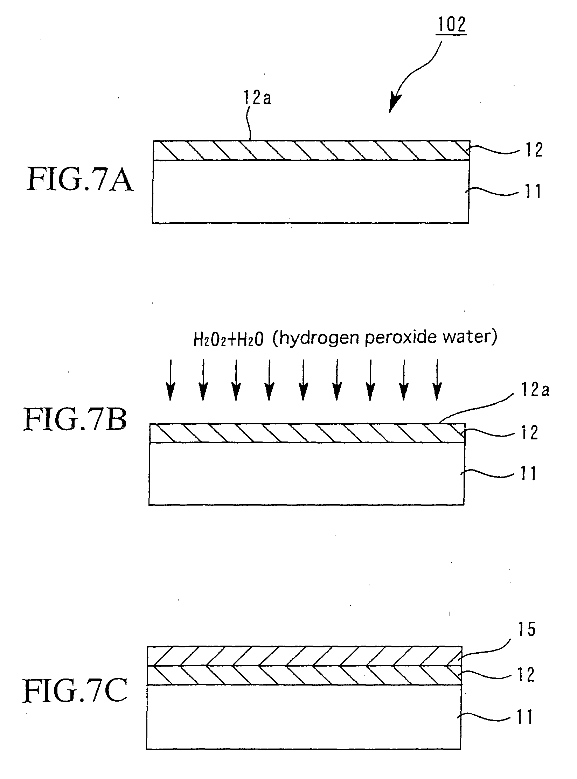

This case will be explained with reference to FIGS.7A to 7C hereunder.

At first, as shown in FIG.7A, the substrate 102 is prepared. This substrate 102 is prepared by forming the silicon nitride film (underlying layer) 12 on the semiconductor substrate 11 made of silicon. The surface of the silicon nitride film 12 serves as the film-forming surface 12a. This silicon nitride film 12 is formed by the well-known film forming method, and an example is the low pressure CVD method using the reaction gas consisting of the dichlorsilane (SiH₂Cl₂) and the ammonia (NH₃). In this case, the film forming temperature of the silicon nitride film 12 is set to about 750 °C, for example.

Then, as shown in FIG.7B, the substrate 102 is dipped into the hydrogen peroxide water (oxidizing agent). By this dipping, the film-forming surface 12a is exposed to the hydrogen peroxide water, and thus the film-forming surface 12a is reformed. The surface reforming conditions in this case are given as follows.
the hydrogen peroxide water concentration : 1.0 to 5.0 %
the hydrogen peroxide water temperature : 60 to 80 °C
the processing time : 10 to 20 minutes

When the surface is reformed in accordance with these conditions, the growth rate ratio become 105 to 106 %.

After the surface is reformed, the substrate 102 is rinsed. Then, the film-forming surface 12a is dried by the heating, the spin drying, etc.. Alternatively, the residual water on the surface may be removed in the isopropyl alcohol steam. When completing this step, the surface reforming process is completed.

Then, as shown in FIG.7C, the substrate 102 is put into the reaction chamber (not shown) of the film forming equipment, and then the high O₃/TEOS film forming gas is supplied into the reaction chamber. Then, the substrate 102 is heated in the temperature range of 400 to 500 °C to make O₃ and TEOS to thermally react with each other. As shown in FIG.7C, the high O₃/TEOS CVD SiO₂ film 15 is formed by holding this state for a predetermined time.

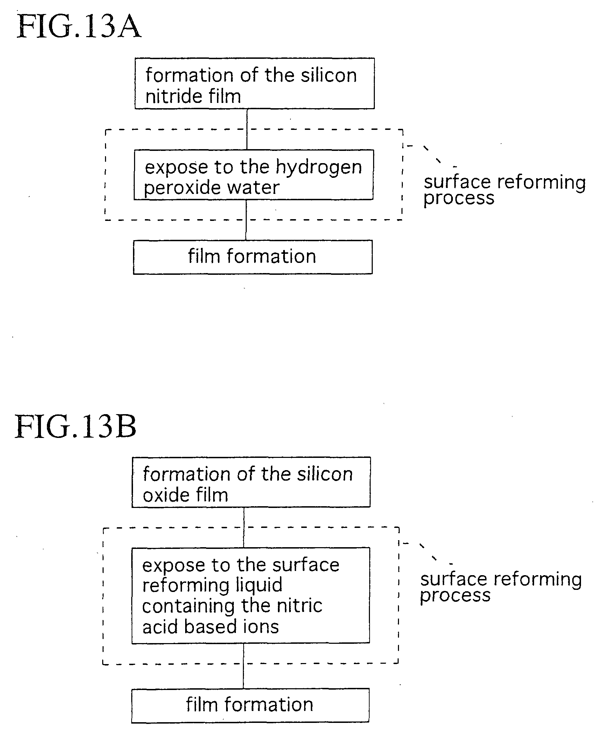

FIG.13A is a flowchart showing the above one-step process when the underlying layer is the silicon nitride film.

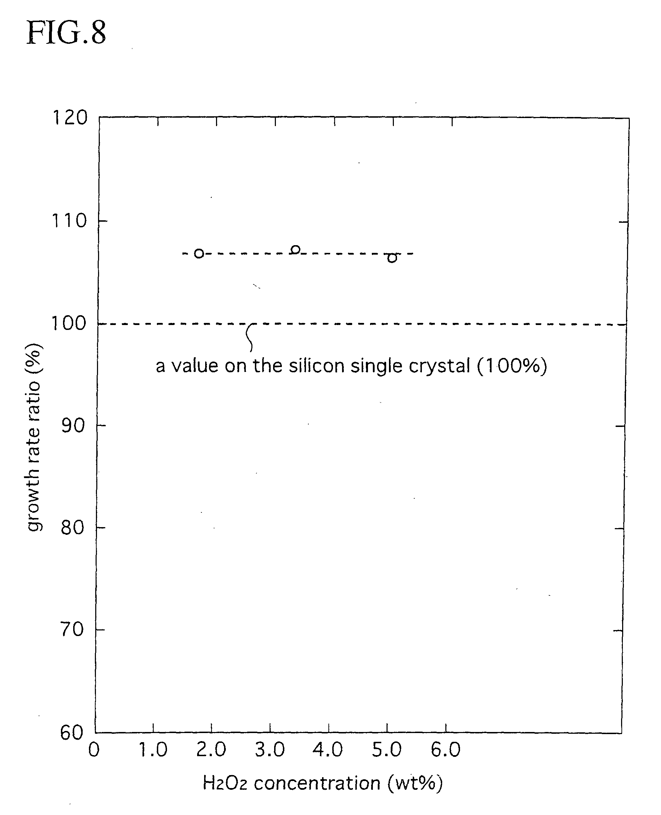

FIG.8 is a graph showing a relationship between the hydrogen peroxide water concentration and the growth rate ratio when the surface reforming conditions are set as follows.
the hydrogen peroxide water temperature : 80 °C
the process time : 10 minutes
It should be noted that the growth rate ratio is calculated based on the growth rate 60 nm/min on the silicon single crystal substrate that has no surface dependency. As shown in FIG.8, when the concentration of the hydrogen peroxide water is in the range of 1.7 to 5 %, the growth rate ratio becomes about 105 %, which is larger than a value (100 %) on the silicon single crystal substrate. This means that the surface dependency of the film-forming surface 12a of the silicon nitride film 12 can be completely eliminated.

According to this one-step process, since the steps (etching by the alkali) required in the first embodiment is not needed, the steps of the surface reforming process can be simplified.

### (The case where the underlying layer is the silicon oxide film)

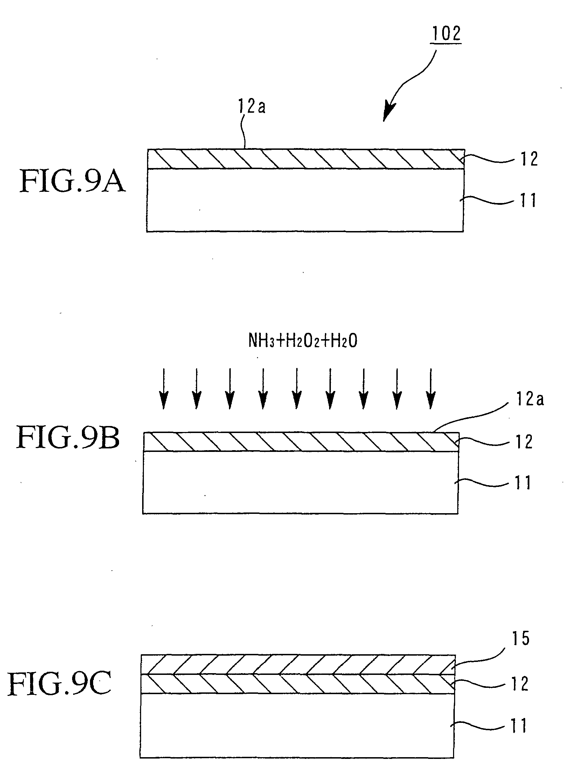

This case will be explained with reference to FIGS.9A to 9C hereunder.

At first, as shown in FIG.9A, the substrate 102 is prepared. This substrate 102 is prepared by forming the silicon oxide film (underlying layer) 12 on the semiconductor substrate 11 made of silicon. For example, the silicon oxide film 12 is formed by putting the semiconductor substrate 11 into the oxidizing furnace (not shown) and then heating it at about 1100 °C in the oxygen atmosphere. Alternatively, the silicon oxide film 12 may be formed by the well-known thermal CVD method, or the plasma CVD method.

Then, as shown in FIG.9B, the substrate 102 is dipped into the surface reforming liquid that consists of the mixed solution of NH₃+H₂O₂+H₂O. It is to be understood that when the term "surface reforming liquid" is appeared in the following explanation, it is meant to refer to the NH₃+H₂O₂+H₂O solution. By this dipping, the film-forming surface 12a is exposed to the surface reforming liquid, and thus the film-forming surface 12a is reformed. The surface reforming conditions and the reforming effect in this case are described later.

After the surface is reformed, the substrate 102 is rinsed. Then, the film-forming surface 12a is dried by the heating, the spin drying, etc.. Alternatively, the residual water on the surface may be removed in the isopropyl alcohol steam. When completing this step, the surface reforming process is completed.

Then, as shown in FIG.9C, the substrate 102 is put into the reaction chamber (not shown) of the film forming equipment, and then the high O₃/TEOS film forming gas is supplied into the reaction chamber. Then, the substrate 102 is heated in the temperature range of 400 to 500 °C to make O₃ and TEOS to thermally react with each other. As shown in FIG.9C, the high O₃/TEOS CVD SiO₂ film 15 is formed by holding this state for a predetermined time.

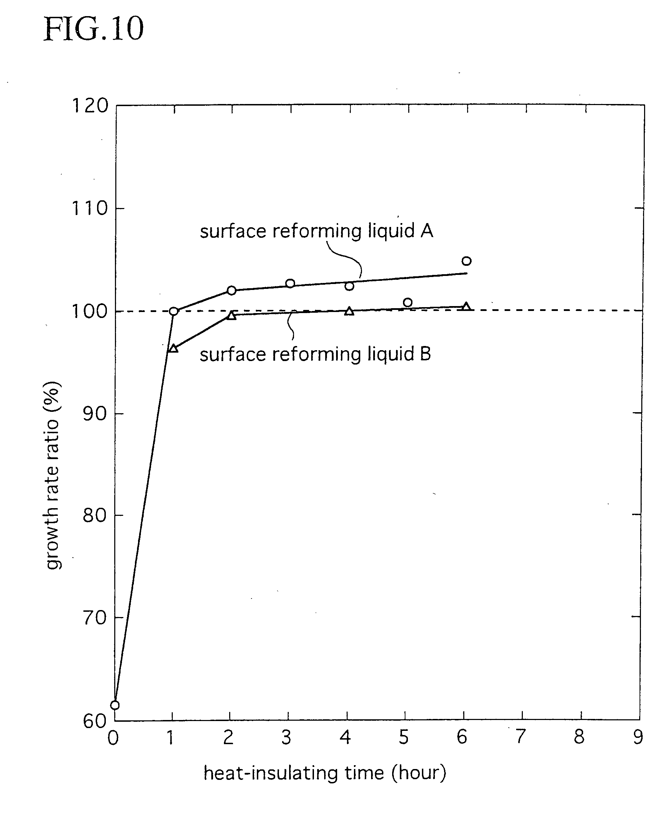

FIG.10 is a graph showing a relationship between a heat-insulating time of the surface reforming liquid and the growth rate ratio obtained by an experiment. In this experiments, surface reforming liquid A and B were used. Composition of the surface reforming liquid A is, by volume ratio, 1:1:5 for the aqueous ammonia (30 wt%), the hydrogen peroxide water (30 wt%), and the pure water respectively. On the other hand, composition of the surface reforming liquid B is, by volume ratio, 1:10:50 for the aqueous ammonia (30 wt%), the hydrogen peroxide water (30 wt%), and the pure water respectively.

It is to be understood that the "heat-insulating time" is defined as the time during which the surface reforming liquids are maintained at a predetermined temperature (80 °C in this experiment) after they are adjusted (i.e., after the aqueous ammonia, the hydrogen peroxide water, and the pure water are mixed to form the surface reforming liquids). In this experiment, the process time is 10 minutes.

As can be seen from FIG.10, the surface dependency of the silicon oxide film 12 cannot be eliminated immediately after the surface reforming liquid is adjusted, and thus the growth rate ratio remains at 60 %. This value is identical to a value exhibited by the silicon oxide film 12 which is not subjected to the reforming treatment. In this manner, the reforming effect is unstable immediately after the surface reforming liquid is adjusted.

However, when one hour elapsed while keeping the temperature of the surface reforming liquid at 80 °C, the growth rate ratio after the process is increased up to 100 % ,and shows a value of more than 100 % when the time further elapsed.

This is because the ammonia is oxidized by the hydrogen peroxide in the surface reforming liquid in which the ammonia concentration is relatively high, thereby the nitrous acid ion (NO₂⁻) and the nitric acid ion (NO₃⁻) are naturally generated in the surface reforming liquid, and these nitric acid based ions (NO₂⁻, NO₃⁻) are effective in eliminating the surface dependency.

Since this one-step process does not need the special equipment to perform it and is carried out by the existing standard wafer cleaning equipment, such one-step process can be easily introduced into the existing manufacturing step. FIG.13B is a flowchart showing this one-step process.

By the way, in the above explanation, it is mentioned that the nitric acid based ions (NO₂⁻, NO₃⁻) in the surface reforming liquid are effective in eliminating the surface dependency. In the following, first to third examinations which back up this assertion will be explained.

### (Result of the first examination)

In this examination, spectrum of the surface reforming liquid A that was heat-insulated at the temperature of 80 °C for 6 hours was measured by the microscopic FTIR (Fourier Transform Infrared Absorption Spectroscopy). It become apparent that when the measured spectrum and the standard spectrum were compared with each other, nonvolatile substance in the liquid was the ammonium nitrate (NH₄NO₃). This shows that the nitric acid based ion was generated in the liquid.

### (Result of the second examination)

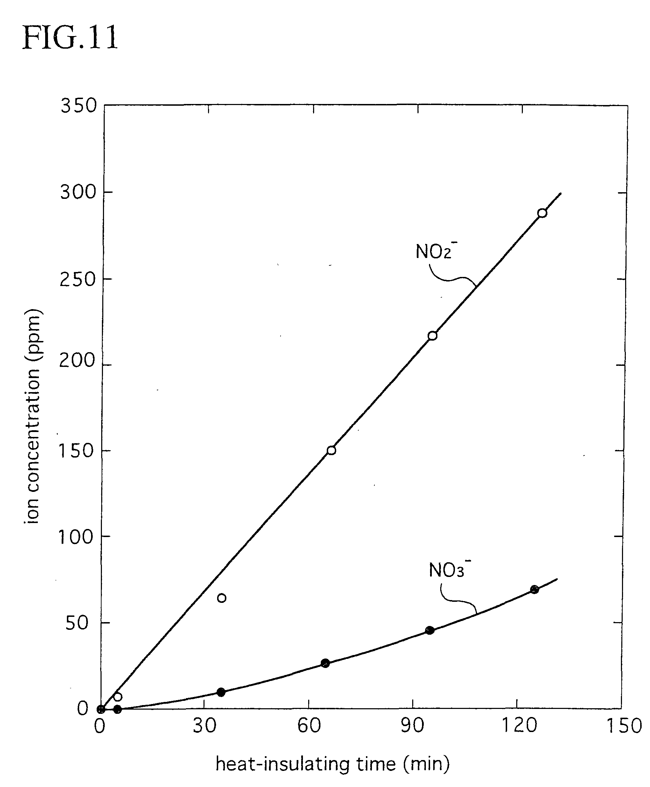

In this examination, a relationship between the heat-insulating time at a temperature of 80 °C and a concentration of the nitric acid based ion in the surface reforming liquid were measured. In this examination, the surface reforming liquid which has a volume ratio of1:3:15 for the aqueous ammonia (30 wt%), the hydrogen peroxide water (30 wt%), and the pure water respectively was used. In this measurement, the ion chromatography was employed. Result of this examination is shown in FIG.11.

As shown in FIG.11, the nitric acid based ion of several 100 ppm is generated in the liquid by one-hour heat-insulation. It can also be observed that the concentration of the nitrous acid ion NO₂⁻, which is precursor of the NO₃⁻, is higher than that of the NO₃.

It should be noted that the increase of the growth rate ratio shown in FIG.10 corresponds well to the increase of the nitric acid based ion shown in FIG.11. Accordingly, it can be understood that any one of NO₂⁻ and NO₃⁻ or both of them are effective in eliminating the surface dependency of the insulating film.

Also, as shown in FIG.11, the concentration of the nitric acid based ions (NO₂⁻, NO₃⁻) in the surface reforming liquid can be adjusted by heat-insulating the surface reforming liquid at a predetermined temperature for a predetermined time after the surface reforming liquid is adjusted.

### (Result of the third examination)

In this examination, a relationship between the concentration of the nitric acid and the growth rate ratio was measured when the nitric acid was intended to be added into the surface reforming liquid. The surface reforming liquid used in this examination is the one which has a volume ratio of 1:4:20 for the aqueous ammonia (30 wt%), the hydrogen peroxide water (30 wt%), and the pure water respectively, and which did not undergo long time elapse after it was adjusted. The surface reforming conditions in this examination are given as follows.
the surface reforming liquid temperature : 80 °C
the process time : 10 minutes

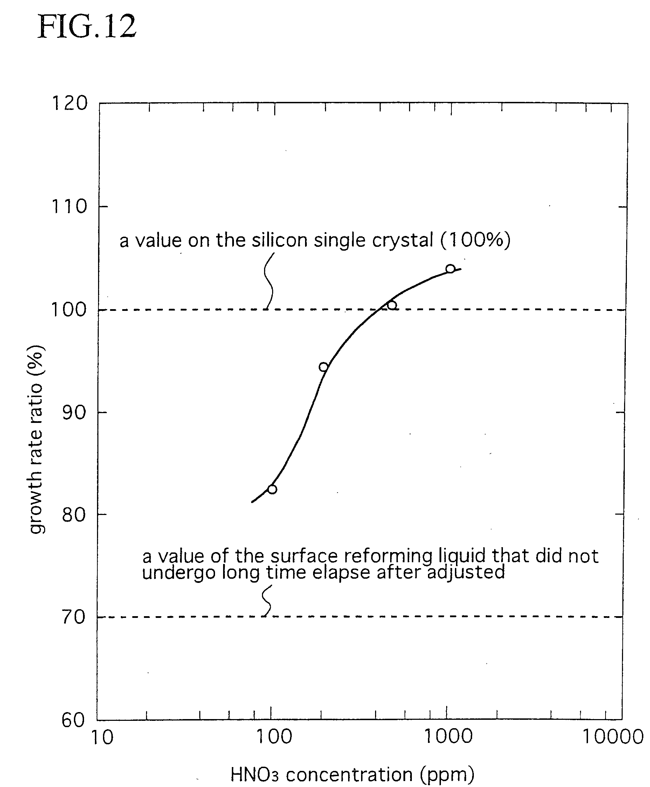

The examination results are shown in FIG.12. An abscissa denotes the concentration of the added nitric acid (HNO₃) in a logarithmic scale. In FIG.12, for the sake of comparison, a value is also depicted which was obtained when the surface reforming process was performed by using the surface reforming liquid that did not undergo long time elapse after it was adjusted. As such surface reforming liquid, the liquid which has a volume ratio of 1:4:20 for the aqueous ammonia (30 wt%), the hydrogen peroxide water (30 wt%), and the pure water, and which did not undergo long time elapse after it was adjusted and contains few nitric acid based ion therein was employed.

It can be understood from FIG.12 that the addition of the nitric acid of about 500PPM permits the surface reforming liquid, which has a middle ammonia concentration such as a volume ratio 1:4:20 and did not undergo long time elapse after it was adjusted, to be effective for eliminating the surface dependency of the silicon oxide film 12.

In this manner, the addition of the nitric acid into the surface reforming liquid makes it possible to remove the unstability of the reforming effect that is exhibited immediately after its adjustment.

In addition, since the nitric acid is intended to be added, the nitric acid based ions (NO₂⁻, NO₃⁻) having a desired concentration can be produced in the surface reforming liquid by adjusting the concentration of the added nitric acid, even when the ammonia concentration in the surface reforming liquid is low. Accordingly, the margin of the ammonia concentration in the surface reforming liquid can be remarkably extended. For example, the surface dependency of the silicon oxide film 12 can be eliminated even by the surface reforming liquid that has the extremely low ammonia concentration, e.g., the surface reforming liquid whose volume ratio is 1:4:200 for the aqueous ammonia (30 wt%), the hydrogen peroxide water (30 wt%), and the pure water respectively.

Followings are an example of preferable surface reforming conditions when the nitric acid is intended to be added.
the ammonia concentration range of the surface reforming liquid : 0.1 to 5.0 %
the nitric acid (HNO₃) concentration range of the surface reforming liquid : 500 to 2000 ppm
the temperature of the surface reforming liquid : 60 to 80 °C
the process time : 10 to 20 minutes

When the surface reformation was performed in accordance with these conditions, the growth rate ratio become 103 to 108 %.

As described above, in the second embodiment of the present invention, the surface reforming process is performed by the one-step process for the underlying layer which is either of the silicon nitride film or the silicon oxide film. Being one-step process, the surface reforming process can be simplified compared to the first embodiment that requires two-steps process to execute the surface reformation

### EXAMPLES

### (First Example)

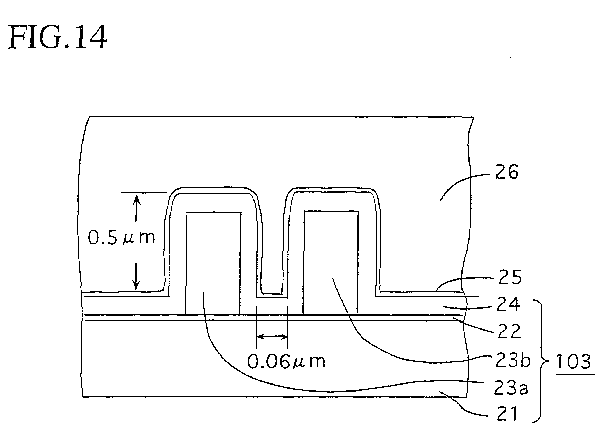

The First Example will be explained with reference to FIG.14 hereunder. In this First Example, the film-forming surface reforming method according to the first embodiment of the present invention was applied to a substrate 103 in which a gate oxide film 22 was formed on a silicon substrate 21, and gate wirings 23a, 23b made of ploysilicon, for example, were formed on the film 22, and a silicon nitride film 24 was formed thereon.

As shown in FIG.14, after the gate wirings 23a, 23b made of ploysilicon were formed, the silicon nitride film (Si₃N₄ film) of about 150 nm, which serves as the underlying layer 24, was formed at 750 °C by the low pressure CVD method using the reaction gas consisting of the dichlorsilane (SiH₂Cl₂) and the ammonia (NH₃).

Then, the film-forming surface of the substrate 103 was etched by exposing it to the etching agent, and then was oxidized by exposing it to the oxidizing agent, whereby the surface reformation was carried out. As the surface reforming conditions, the ammonia aqueous solution was used as the etching agent, the concentration of the ammonia aqueous solution was changed in the range of 0.05 wt% to 1 wt%, the process temperature was set to 80 °C, and the process time was set to 10 minutes. Then, after the rinse, the film-forming surface was oxidized by dipping it into the hydrogen peroxide water whose concentration was 4 wt% and whose temperature was 80 °C. As a result, a chemically stable thin layer 25 (underlying layer) made of the silicon oxide could be formed.

Then, a high O₃/TEOS CVD SiO₂ film 26 of 600 nm film thickness was formed on the surfaces of the reformed underlying layers 24, 25. As the film forming conditions for the high O₃/TEOS CVD SiO₂ film 26, the ozone was contained in O₂ by 8 mol%, i.e., the so-called high concentration, and the ozone, O₂, and TEOS constitute the O₃/TEOS reaction gas. And the heating temperature of the substrate 103 was set to 450 °C.

As shown in FIG.14, after the film-forming surface reforming method of the present invention was applied to the film-forming surface having the unevenness such as the gate wirings 23a, 23b, etc., a high O₃/TEOS CVD SiO₂ film 26 was formed by virtue of the CVD method using the high O₃/TEOS film forming gas. Due to the surface reformation, the high O₃/TEOS CVD SiO₂ film 26 exhibited excellent recess filling property and good step coverage.

### (Second Example)

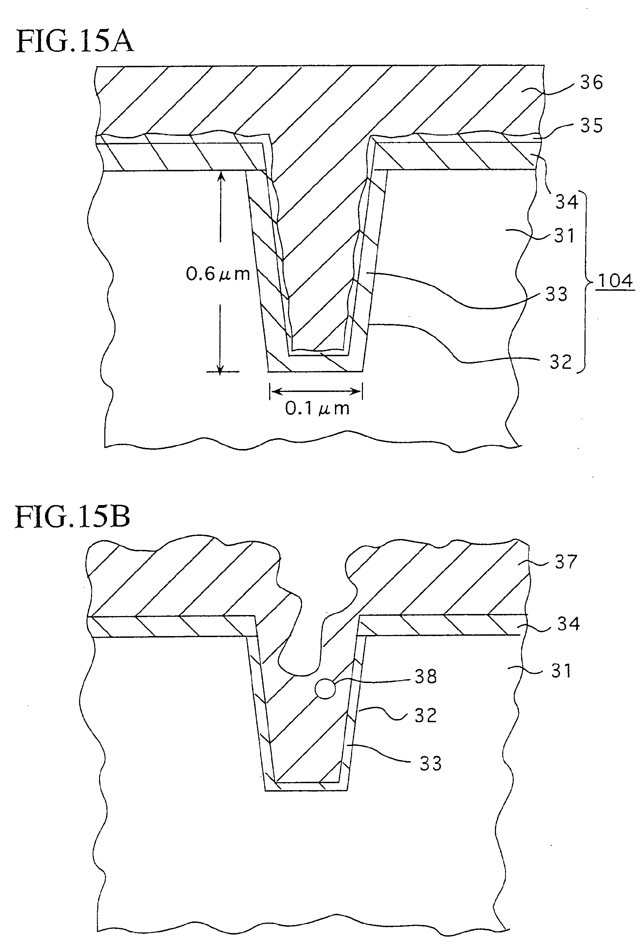

Then, Second Example will be explained with reference to FIG.15A. In Second Example, the first embodiment of the present invention was applied to the film-forming surface on which recesses having a narrow width and deep depth were present. For the sake of comparison, Comparative Example in which the film was formed without performing the surface reforming process is shown in FIG.15B.

FIG.15A is a sectional view showing a sectional structure when a high O₃/TEOS CVD SiO₂ film 36 was formed after the film-forming surface was reformed. FIG.15B is a sectional view showing a sectional structure when a high O₃/TEOS CVD SiO₂ film 37 was formed without the film-forming surface reforming process. In FIG.15B, same symbols as those in FIG.15A are affixed to same elements as those in FIG.15A.

As shown in FIG.15A, a recess 32 that has a width of about 0.1 *µ*m and a depth of about 0.6 *µ*m was formed on a semiconductor substrate 31 made of silicon, and then thermal oxide films 33, 34 made of SiO₂ were formed as the underlying layer on a surface of the semiconductor substrate 31. Above elements constitute a film-formed substrate 104.

Then, the high O₃/TEOS CVD SiO₂ films 36, 37 were formed on a surface of the underlying layer, and the recess filling property and the step coverage were examined.

As the reforming agent employed in the first step of the surface reforming process, unlike the First Example, the mixed solution of the aqueous ammonia and the hydrogen peroxide water was employed. The mixed solution was heated up to the temperature of 50 to 80 °C, and the substrate 104 was dipped into this mixed solution for 10 minutes.

Then, in the oxidizing process of the second step, the temperature of the hydrogen peroxide water having the concentration of about 4 wt% was set to 80 °C, and then the substrate 104 was dipped into it for 10 minutes. By this dipping, the silicon oxide film (underlying layer) 35 was formed on surface layers of the thermal oxide films 33, 34.

In this example, as the film forming conditions of the high O₃/TEOS CVD SiO₂ films 36, 37, the ozone concentration and the heating temperature of the substrate 104 were set identical to the First Example.

It can be understood from FIG.15A that the high O₃/TEOS CVD SiO₂ film 36 that has no void and whose surface is planarized is formed in the sample to which the reforming process of the film-forming surface reforming method of the present invention is applied.

In contrast, as shown in FIG.15B, it can be understood that, when the high O₃/TEOS CVD SiO₂ film 37 was formed without the surface reforming process, a void 38 was generated and the surface of the film 37 was corrugated and the flat film cannot be obtained.

As described above, if the surface reformation for the underlying layers 33, 34 having very narrow concave regions such as the recess 32, etc. is performed by using two-step process of the etching process and the oxidizing process, the recess filling property and the step coverage of the high O₃/TEOS CVD SiO₂ film 36 for the recess 32 can be improved.

In the above embodiments, the high O₃/TEOS CVD SiO₂ film is employed as the insulating film formed on the film-forming surface. However, the present invention is not limited to this specific example, and the insulating film that is formed by using a combination of other silicon-containing organic compound (e.g., siloxane such as hexamethyldisiloxane (HMDSO), etc. or alkoxysilane such as trimethoxysilane (TMS), etc.) and the oxidizing gas (e.g., O₂, O₃, NO, N₂O, etc.) may be employed alternatively.

Also, as the insulating film that is formed on the film-forming surface, in addition to the SiO₂ film that is very congenial to the film-forming surface, any one of the PSG (Phosphosilicate glass) film, the BSG (Borosilicate glass) film, and the BPSG (Borophosphosilicate) film may be employed. As the film forming gas for forming the PSG film, gas mixture of O₃, TEOS, and TMP (Trimethylphosphite:P(OCH₃)₃) or TMOP (Trimethylphosphate: PO(OCH₃)₃) may be employed. Also, as the film forming gas for forming the BSG film, gas mixture of O₃, TEOS, and TMB (Trimethylborate:B(OCH₃)₃) may be employed. In addition, as the film forming gas for forming the BPSG film, gas mixture of O₃, TEOS, TMB, and TMP or TMOP may be employed.

If the above reforming process is executed while applying the ultrasonic wave or the megasonic wave to the substrates 102, 103, and 104, the reforming effect can be improved. The processing effect can also be improved by circulating the processing solution (e.g., etching agents, oxidizing agents, and NH₃+H₂O₂+H₂O solution) by virtue of a pump (not shown) to make the solution collide against the film-forming surface.

As described above, according to the present invention, the gas or the aqueous solution containing ammonia, hydrazine, amine, amino compound or their derivative is brought into contact with the film-forming surface, and then the gas or the aqueous solution containing hydrogen peroxide, ozone, oxygen, nitric acid, sulfuric acid or their derivative is brought into contact with the film-forming surface.

That is, the film-forming surface is firstly chemically activated by the etching, and secondly the film-forming surface is oxidized. Therefore, the film-forming surface can be oxidized at the low temperature close to the room temperature, and thus the surface dependency can be easily eliminated.

Particularly, since the aqueous solution containing the ammonia or the hydrazine compound has a small surface tension and the gas of the reforming agent can be diffused into the narrow and deep recess portion, the surface dependency in such minute recess portion can be eliminated.

Accordingly, the interlayer or cover insulating film, which is formed using the thermal CVD method and is formed on the film-forming surface whose surface dependency is eliminated, exhibits no surface roughness and voids, together with exhibiting no reduction in the film forming rate, and can fill the narrow and deep recess portion completely.

Also, if the film-forming surface is the surface of the silicon nitride film, the surface dependency of the insulating film can be eliminated merely by exposing the surface to the hydrogen peroxide water.

In addition, if the film-forming surface is the surface of the silicon oxide film, the surface dependency of the insulating film can be eliminated merely by exposing the surface to the aqueous solution containing any one of NO₂⁻ and NO₃⁻.

As a result, the miniaturization and the higher density of the device can be achieved.

## Claims

1. A film-forming surface reforming method comprising the steps of:
bringing a gas or an aqueous solution containing any one selected from the group consisting of ammonia, hydrazine, amine, amino compound, and their derivative into contact with a film-forming surface (12a) before an insulating film (15) is formed on the film-forming surface (12a) of a substrate (102); and
bringing a gas or an aqueous solution containing any one selected from the group consisting of hydrogen peroxide, ozone, oxygen, nitric acid, sulfuric acid, and their derivative into contact with the film-forming surface (12a).

2. A film-forming surface reforming method according to claim 1, wherein any one of a silicon oxide film and a silicon nitride film is exposed on the film-forming surface (12a).

3. A film-forming surface reforming method according to claim 2, wherein any one of a semiconductor layer and a metal layer in addition to any one of the silicon oxide film and the silicon nitride film is exposed on the film-forming surface (12a).

4. A film-forming surface reforming method according to any one of claims 1 to 3, wherein the amine is a compound having a chemical formula NRₙH₃₋ₙ (n=1,2,3, R: alkyl group).

5. A film-forming surface reforming method according to any one of claims 1 to 3, wherein the amino compound is a compound having a chemical formula RNH₂ (R: organic group).

6. A semiconductor device manufacturing method comprising the steps of:
bringing a gas or an aqueous solution containing any one selected from the group consisting of ammonia, hydrazine, amine, amino compound, and their derivative into contact with a film-forming surface before an insulating film (26, 36) is formed on the film-forming surface of a substrate (103, 104);
reforming the film-forming surface by bringing a gas or an aqueous solution containing any one selected from the group consisting of hydrogen peroxide, ozone, oxygen, nitric acid, sulfuric acid, and their derivative into contact with the film-forming surface; and
forming the insulating film (26, 36) on the reformed film-forming surface.

7. A semiconductor device manufacturing method comprising the steps of:
exposing a film-forming surface (12a) of a silicon nitride film (12) to a hydrogen peroxide water; and
forming an insulating film (15) on the film-forming surface (12a) after the film-forming surface (12a) is exposed to the hydrogen peroxide water.

8. A semiconductor device manufacturing method comprising the steps of:
exposing a film-forming surface (12a) of a silicon oxide film (12) to an aqueous solution containing any one of NO₂⁻ and NO₃⁻; and
forming an insulating film (15) on the film-forming surface (12a) after the film-forming surface (12a) is exposed to the aqueous solution.

9. A semiconductor device manufacturing method according to claim 8, wherein a mixed solution containing an ammonia (NH₃), a hydrogen peroxide (H₂O₂), and a pure water (H₂O) is employed as the aqueous solution.

10. A semiconductor device manufacturing method according to claim 8, wherein a nitric acid (HNO₃) is added to the aqueous solution.

11. A semiconductor device manufacturing method comprising the steps of:
preparing a mixed solution containing an ammonia (NH₃), a hydrogen peroxide (H₂O₂), and a pure water (H₂O);
heat-insulating the mixed solution at a predetermined temperature for a predetermined time so that NO₂⁻ and NO₃⁻ concentrations in the mixed solution are set to a desired concentration;
exposing a film-forming surface (12a) of a silicon oxide film (12) to the mixed solution after the heat-insulating; and
forming an insulating film (15) on the film-forming surface (12a) after the film-forming surface (12a) is exposed to the mixed solution.

12. A semiconductor device manufacturing method according to any one of claims 6 to 11, wherein the insulating film (15, 26, 36) is a silicon-containing insulating film which is formed by a thermal chemical vapor deposition employing a reaction gas that contains an ozone-containing gas and a tetraethylorthosilicate.
